# EUROPÄISCHE PATENTSCHRIFT

(11) **EP 1 748 090 B1**
(45) Veröffentlichungstag und Bekanntmachung des Hinweises auf die Patenterteilung: **27.01.2010**
(21) Anmeldenummer: 06015409.3
(22) Anmeldetag: 25.07.2006
(51) Int. Cl.: C23C 14/00

(54) **Vorrichtung zum Behandeln von Substraten**
Substrates heat treatment apparatus
Dispositf de traitement de substrats

(30) Priorität: 28.07.2005 DE 102005035904
(43) Veröffentlichungstag der Anmeldung: 31.01.2007
(73) Patentinhaber: Leybold Optics GmbH, 63755 Alzenau (DE)
(72) Erfinder: Fukarek, Wolfgang, Dr., 01477 Fischbach (DE); Hauswald, Ralf, 01814 Prossen (DE); Willkommen, Udo, 01328 Dresden (DE)
(74) Vertreter: Pohlmann, Bernd Michael

(56) Entgegenhaltungen:
- EP-A1- 0 863 226
- WO-A-03/083162
- WO-A2-2006/069774
- DE-A1- 3 214 256
- US-A- 3 889 632
- US-A- 3 986 478
- US-A- 3 993 018
- US-A- 5 096 364

## Beschreibung

Die Erfindung betrifft eine Vorrichtung zum Behandeln, insbesondere zum Beschichten von Substraten gemäß dem Oberbegriff des unabhängigen Anspruchs.

Bei kontinuierlichen und/oder automatisierten Prozessen zum Behandeln und/oder Beschichten von Substraten, beispielsweise von Wafem oder Disketten, in Vakuumanlagen erfolgt das Be- und Entladen der Substrathalter mit den Substraten unter Aufrechterhaltung des Vakuums in einer Vakuumkammer. Die Be- und Entladung der Substrathalter erfolgt dabei über eine oder mehrere Vakuumschleusen mit Handlingsystemen, so dass ein aufwendiges Belüften und erneutes Evakuieren der Vakuumkammer beim Substratwechsel entfallen kann und Substrate effektiv in großen Stückzahlen und/oder unter Reinraumbedingungen hergestellt werden können.

Derartige Anlagen können als "Cluster"-Anlagen mit rotatorischen und ggf. radialen Transportwegen der Substrate durch mehrere Stationen ausgeführt sein. Ein Substratwechsel erfolgt dabei in einer Be- und Entladestation, beispielsweise durch Austausch des Substratträgers, wie in der DE 39 12295 A1 beschrieben.

In anderen Anlagen, beispielsweise mit nur einer Behandlungskammer und darin angeordnetem Substrathalter zur Aufnahme mehrerer Substrate, sind die Vakuumschleusen mit Handlingsystemen ausgestattet, welche die zu behandelnden Substrate möglichst genau und reproduzierbar zwischen Vakuumschleuse und Vakuumkammer transportieren und auf dem Substratträger positionieren.

Bekannte Handlingsysteme arbeiten dabei mit horizontal und vertikal beweglichen Trägem bzw. Schwenkarmen und/oder Greifern, um das Substrat zu transportieren und auf einem Substrathalter zu positionieren. Der Substrathalter ist dabei als Substratteller horizontal in der Vakuumkammer angeordnet und um eine vertikale Achse drehbar.

Andere Handlingsysteme, wie beispielsweise in der DE 32 14 256 A1 offenbart, verwenden zum Transport der Substrate von einem Magazin, welches sich in der Vakuumschleuse befindet, in die Vakuumkammer und zum Transport der Substrate aus der Vakuumkammer in das Magazin horizontal und vertikal bewegliche Substratträger.

Der Substratteller ist zum Be- und Entladen ebenfalls in horizontaler und/oder vertikaler Richtung verschiebbar.

Die bekannten Handlingsysteme sind jedoch nur zum Substratwechsel für Vakuumanlagen mit horizontal angeordneten Substrathaltern geeignet.

Ferner sind aus der US 3,889,632 sowie der US 3, 968, 478 Vorrichtungen zur Vakuumbehandlung von Wafern und Substraten bekannt mit einem in einer Vakuumkammer angeordneten flachen Substrathalter, der um eine vertikale Drehachse bewegbar ist. Der Substrathalter ist ferner um eine senkrecht zur Drehachse verlaufende, vollständig in der Kammer liegende Achse schwenkbar.

Aufgabe der Erfindung ist es in einer Anlage zum Behandeln von Substraten einen Substratwechsel auf beliebigen, insbesondere auf kalottenförmigen Substrathaltern unter Aufrechterhaltung des Vakuums in der Vakuumkammer mit einfachen Mitteln zu ermöglichen.

Die Lösung gelingt mit einer Vorrichtung gemäß des selbständigen Anspruchs 1. Weitere vorteilhafte Ausgestaltungen der erfindungsgemäßen Vorrichtung sind den abhängigen Ansprüchen zu entnehmen.

Die erfindungsgemäße Vorrichtung zum Behandeln, insbesondere zum Beschichten von Substraten, umfasst zumindest eine Vakuumkammer mit darin angeordnetem, um eine vertikale Drehachse bewegbaren Substrathalter, welcher um eine senkrecht zur Drehachse verlaufende Kippachse schwenkbar ist, zumindest eine Vakuumschleuse zum Ein- und/oder Ausschleusen von Substraten mit einem Handlingsystem zum Transport von Substraten von der Vakuumschleuse in die Vakuumkammer und/oder zurück und zum Be- und Entladen des Substrathalters, wobei der Substrathalter kalottenförmig um die Drehachse angeordnete Segmente, wobei jeweils ein Segment des Substrathalters zum Substratwechsel in Bezug auf das Handlingsystem ausgerichtet werden kann.

Dadurch kann jeweils ein Segment des Substrathalters zum Substratwechsel in Bezug auf ein Handlingsystem flexibel ausgerichtet werden. Der Substrathalter kann dabei Segmente aufweisen, die in einem beliebigen Winkel zur Drehachse angeordnet sind.

Die erfindungsgemäße Vorrichtung umfasst vorzugsweise eine Vakuumschleuse zum Ein- und Ausschleusen der Substrate. Ausführungen mit einer Vakuumschleuse zum Einschleusen, einer weiteren Vakuumschleuse zum Ausschleusen und jeweils einem Handlingsystem liegen jedoch ebenfalls im Rahmen der Erfindung.

Vorzugsweise ist die Vakuumschleuse seitlich, insbesondere in Höhe des Substrathalters, an der Vakuumkammer angeordnet, sodass die Transportwege zwischen Vakuumschleuse und Substrathalter minimal sind.

In einer vorteilhaften Ausgestaltung der Erfindung ist zumindest ein Segment, vorzugsweise jedoch nacheinander jedes Segment, welche jeweils einem Segmentabschnitt des Substrathalters zugeordnet ist, zum Be- und/oder Entladen des Substrathalters mit zumindest einem Substrat horizontal positionierbar, sodass einfache Handlingsysteme eingesetzt werden können. Vorzugsweise weist das Handlingsystem zum Transport der Substrate und/oder zum Be- und Entladen des Substrathalters horizontal und/oder vertikal bewegbare Träger, Schwenkarme und/oder Greifer auf.

In einer alternativen vorteilhaften Ausgestaltung der Erfindung erfolgt der Austausch der Substrate durch den Austausch der mit zumindest einem Substrat bestückten Segmente, wobei vorzugsweise nacheinander jeder Segmentabschnitt des Substrathalters zum Be- und/oder Entladen des Substrathalters mit einem Segment horizontal positionierbar ist.

Um kurze und einfache Transportwege sowie ein einfaches Be- und Entladen des Substrathalters zu ermöglichen ist es von Vorteil, die Vakuumschleuse mit dem Handlingsystem derart an der Vakuumkammer anzuordnen, dass ein horizontal positionierter Segmentabschnitt gegenüberliegend angeordnet werden kann und dabei die horizontale Bewegungsebene des Handlingsystems geodätisch oberhalb der horizontalen Ebene des horizontal positionierten Segmentabschnittes liegt. Das Handlingsystem kann dabei vorzugsweise einen Träger zum Beladen des Substrathalters aufweisen, der horizontal in Richtung des horizontal positionierten Segmentabschnittes und vertikal nach unten in Richtung des horizontal positionierten Segmentabschnittes und/oder zum Entladen in umgekehrter Richtung bewegbar ist.

Der Substrathalter ist sowohl zur Rotation während der Behandlung in der Vakuumkammer als auch zur Positionierung zum Be- und Entladen des Substrathalters mit Substraten bzw. Segmenten um eine vertikale Achse drehbar. Zur weiteren Positionierung der Segmentabschnitte, insbesondere in eine horizontale Lage, ist der Substrathalter außerdem um eine senkrecht zur Drehachse verlaufenden Kippachse schwenkbar. Zur Ausführung der Drehbewegung um die vertikale Achse ist der Substrathalter vorzugsweise mit einem Drehantrieb verbunden. Zur Realisierung der Kippbewegung umfasst der Drehantrieb insbesondere eine Halterung, wobei die Halterung zumindest eine auf der Kippachse angeordnete Halterungsachse aufweist, die mit einem Lager verbunden ist, sodass der Drehantrieb um die Kippachse schwenkbar ist. Vorzugsweise umfasst der Drehantrieb zwei Halterungsachsen, die jeweils mit einem Lager verbunden sind. Zur Realisierung der Schwenkbewegung ist die Halterung vorzugsweise mit einem Kippantrieb verbunden.

Der Drehantrieb umfasst in einer weiteren vorteilhaften Ausführungsform eine Vakuumdrehdurchführung, über welche der Substrathalter mit einem Drehmotor verbunden ist.

Der Drehantrieb ist vorzugsweise in einer Deckelöffnung der Vakuumkammer vakuumdicht angeordnet, wobei die Deckelöffnung so groß ist, dass der Drehantrieb in der Deckelöffnung schwenkbar ist. Um die so entstehende Lücke zwischen der Deckelöffnung und darin schwenkbaren Drehantrieb vakuumdicht auszuführen, ist vorzugsweise ein Balg vorgesehen, der die Deckelöffnung vakuumdicht mit dem Drehantrieb verbindet und eine Schwenkbewegung des Drehantriebs in der Deckelöffnung zulässt.

Vorzugsweise verläuft die Kippachse des Drehantriebes außerhalb der Vakuumkammer , sodass die Lager mit den Halterungsachsen auf dem Deckel außerhalb der Kammer angeordnet werden können.

Die Erfindung kann durch unterschiedlichste Ausführungsformen realisiert werden. Eine bevorzugte Ausführung wird im folgenden Ausführungsbeispiel näher erläutert.

Es zeigen dazu
- Figur 1:: eine perspektivische Ansicht von oben auf einen Ausschnitt der erfindungsgemäßen Vorrichtung
- Figur 2:: eine Seitenansicht eines Ausschnittes der erfindungsgemäßen Vorrichtung
- Figur 3:: einen Schnitt durch einen Ausschnitt der erfindungsgemäßen Vorrichtung

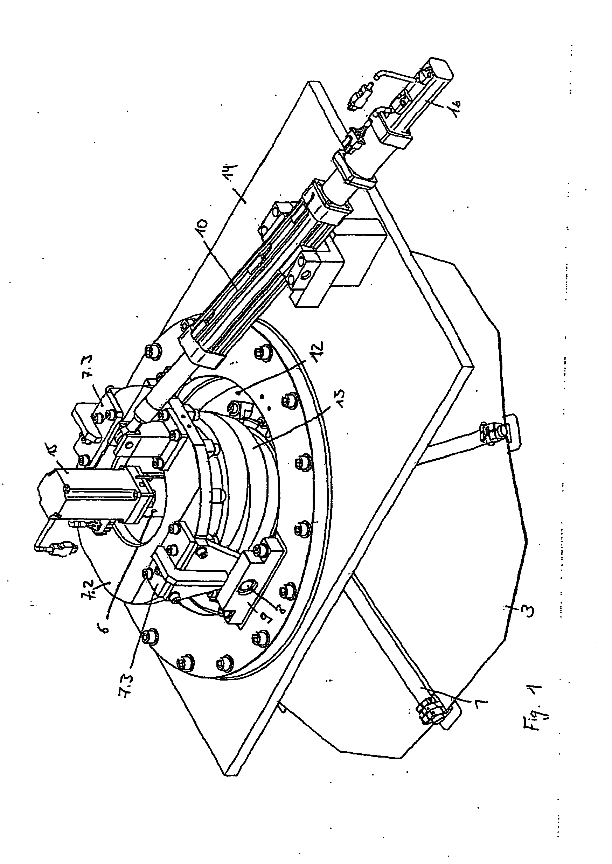

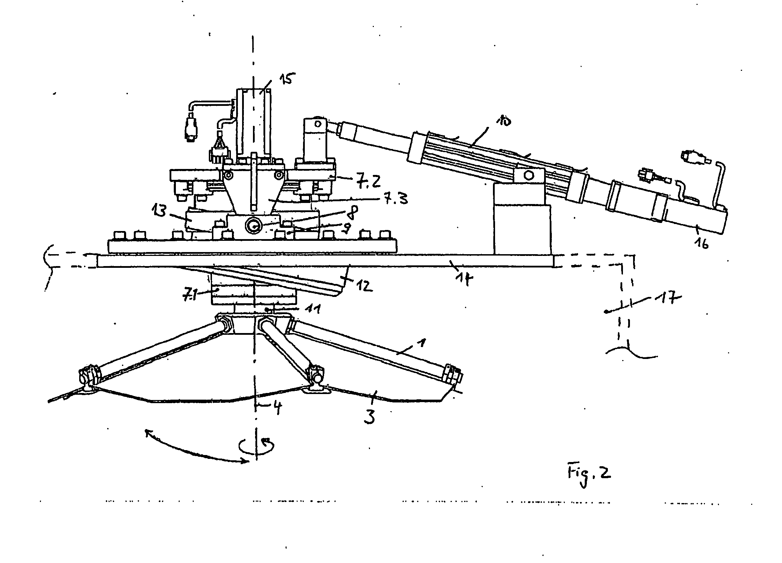

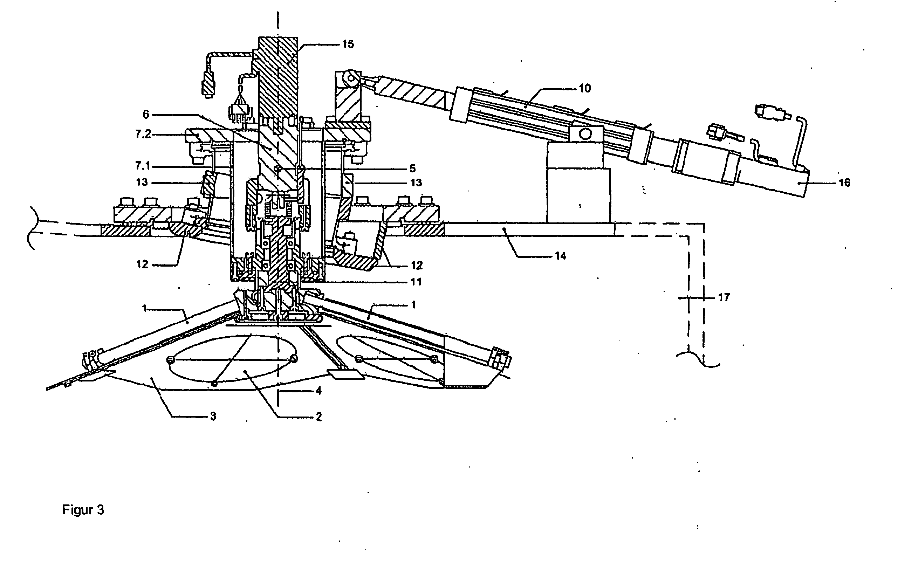

Die Figuren 1 bis 3 zeigen einen Ausschnitt einer beispielhaften Ausführungsform der Erfindung in unterschiedlichen Darstellungen. In Figur 1 ist eine perspektivische Ansicht, in Figur 2 eine Seitenansicht und in Figur 3 ein Schnitt der selben Ausführungsform dargestellt.

Die beispielhafte erfindungsgemäße Vorrichtung ist eine Beschichtungsanlage zum Beschichten von scheibenförmigen Substraten 2, beispielsweise zum Aufdampfen einer oder mehrerer metallischer oder dielektrischer Schichten auf Wafer aus Silizium oder Glas insbesondere unter Lift-off-Geometrie. Die Vakuumanlage umfasst eine Vakuumkammer 17 mit darin angeordnetem kalottenförmigen Substrathalter 1, eine seitlich an der Vakuumkammer 17 angeordnete Vakuumschleuse mit einem Handlingsystem (nicht dargestellt) und weitere zur Erzeugung eines Vakuums und zur Beschichtung der Substrate 2 erforderliche Bestandteile einer Beschichtungsanlage.

Der Substrathalter 1 ist um die Drehachse 4 drehbar und um eine senkrecht zur Drehachse 4 verlaufende Kippachse 5 schwenkbar und weist sechs kalottenförmig um die Drehachse 4 angeordnete Segmente 3 auf, die jeweils einem Segmentabschnitt des Substrathalters 1 zugeordnet sind. Auf jedem Segment 3 ist jeweils ein scheibenförmiges Substrat 2 angeordnet.

Der Substrathalter 1 ist mit dem Drehantrieb 6 verbunden. Der Drehantrieb 6 umfasst einen Drehmotor 15, eine Vakuumdrehdurchführung 11 für die Antriebswelle des Drehmotors 15, die mit dem Substrathalter 1 gekoppelt ist und eine Halterung 7. Die Halterung 7 ist mehrteilig und besteht im wesentlichen aus einer kreisförmigen Hülse 7.1, welche die Vakuumdrehdurchführung 11 umschließt und an ihrem unteren Ende befestigt ist, einer am oberen Ende der Hülse 7.1 befestigten Halterungsscheibe 7.2 und zwei an der Halterungsscheibe 7.2 befestigten Trägem 7.3. Zur Realisierung der Schwenkbewegung des Substrathalters 1 mit dem Drehantrieb 6 sind die Träger 7.3 der Halterung 7 über jeweils einer Halterungsachse 8 in Lagern 9 schwenkbar gelagert, wobei die Halterungsachsen 8 entlang der Kippachse 5 verlaufen. Die Lager 9 sind auf dem Deckel 14 der Vakuumkammer 17 befestigt. Der Hülse 7.1 mit der Vakuumdrehdurchführung 11 sind durch eine Deckelöffnung 12 der Vakuumkammer 17 geführt. Dabei ist die Deckelöffnung 12 derart ausgebildet, dass der Drehantrieb 6 in der Deckelöffnung 12 um die Kippachse 5 schwenkbar ist.

Zum vakuumdichten Verschluss des sich zwischen der Deckelöffnung 12 und dem Drehantrieb 6 ausbildenden Spaltes und zur gleichzeitigen Aufrechterhaltung der Bewegungsfreiheit des Drehantriebes 6 in der Deckelöffnung 12 ist zwischen der Halterungsscheibe 7.2 und der Deckelöffnung 12 umlaufend ein Balg 13 befestigt.

Die Halterungsscheibe 7.2 ist mit dem Kippantrieb 10 gekoppelt und kann, angetrieben vom Kippmotor 16, den Drehantrieb 6 mit dem Substrathalter 1 um die Kippachse schwenken.

Während der Beschichtung der Substrate 2 ist die Drehachse 4 vertikal ausgerichtet und der Substrathalter 1 rotiert um die Drehachse 4.

Um die Segmente 3 für einen Substratwechsel auszutauschen, ist jeder der sechs Segmentabschnitte des Substrathalters 1 nacheinander horizontal auf das Handlingsystem auszurichten. Dazu wird der entsprechende Segmentabschnitt des Substrathalters 1 mit einer Drehbewegung des Substrathalters 1 um die horizontal ausgerichtete Drehachse 4 gegenüber der Vakuumschleuse positioniert, mit einer Schwenkbewegung des Substrathalters 1 um die senkrecht zur Drehachse 4 verlaufende Kippachse 5 in eine horizontale Lage gebracht und mittels des Handlingsystems ausgetauscht. Zum Be- und Entladen des Substrathalters 1 werden dabei die mit jeweils einem Substrat 2 bestückten Segmente 3 mit Hilfe des Handlingsystems über die Vakuumschleuse in die Vakuumkammer 17 eingeschleust bzw. aus der Vakuumkammer 17 herausgeschleust. Die Träger bzw. Greifer des Handlingsystems sind zum Transport der Segmente 3 horizontal und vertikal beweglich.

Zum weiteren Substratwechsel wird der Substrathalter 1 weiter um die, nunmehr geschwenkte, Drehachse 4 bewegt, bis sich ein weiteres Segment 3 in horizontaler Lage gegenüber der Vakuumschleuse befindet. Nachdem alle Segmente ausgetauscht wurden, wird der Substrathalter wieder um die Kippachse 5 geschwenkt wobei die Drehachse 4 wieder vertikal ausgerichtet wird.

Die Koordination der Bewegungsabläufe kann dabei über eine Steuerungseinheit erfolgen.

### BEZUGSZEICHENLISTE

- 1: Substrathalter
- 2: Substrat
- 3: Segment
- 4: Drehachse
- 5: Kippachse
- 6: Drehantrieb
- 7: Halterung
- 7.1: Hülse
- 7.2: Halterungsscheibe
- 7.3: Träger
- 8: Halterungsachse
- 9: Lager
- 10: Kippantrieb
- 11: Vakuumdrehdurchführung
- 12: Deckelöffnung
- 13: Balg
- 14: Deckel der Vakuumkammer
- 15: Drehmotor
- 16: Kippmotor
- 17: Vakuumkammer

## Patentansprüche

1. Vorrichtung zum Behandeln, insbesondere zum Beschichten, von Substraten (2), umfassend eine Vakuumkammer (17) mit darin angeordnetem, um eine vertikale Drehachse (4) bewegbaren Substrathalter (1), welcher um eine senkrecht zur Drehachse (4) verlaufende Kippachse (5) schwenkbar ist, eine Vakuumschleuse zum Ein- und Ausschleusen von Substraten sowie ein Handlingsystem zum Transport von Substraten (2) und zum Be- und Entladen des Substrathalters (1), **dadurch gekennzeichnet, dass** der Substrathalter (1), kalottenförmig um die Drehachse (4) angeordnete Segmente (3) umfasst, wobei jeweils ein Segment des Substrathalters zum Substratwechsel in Bezug auf das Handlingsystem ausrichtbar ist.

2. Vorrichtung nach Anspruch 1, **dadurch gekennzeichnet, dass** das der Substrathalter (1) mit einem Drehantrieb (6) verbunden ist.

3. Vorrichtung nach Anspruch 2, **dadurch gekennzeichnet, dass** der Drehantrieb (6) eine Halterung (7) umfasst, wobei die Halterung (7) zumindest eine auf der Kippachse (5) angeordnete Halterungsachse (8) aufweist, die mit einem Lager (9) verbunden ist.

4. Vorrichtung nach Anspruch 3, **dadurch gekennzeichnet, dass** die Halterung (7) mit einem Kippantrieb (10) verbunden ist.

5. Vorrichtung nach einem der Ansprüche 2. bis 4, **dadurch gekennzeichnet, dass** der Drehantrieb (6) eine Vakuumdrehdurchführung (11) aufweist.

6. Vorrichtung nach einem der vorhergehenden Ansprüche 2 bis 5, **dadurch gekennzeichnet, dass** der Drehantrieb (6) in einer Deckelöffnung (12) der Vakuumkammer (17) vakuumdicht angeordnet ist, wobei der Drehantrieb (6) in der Deckelöffnung (12) schwenkbar ist.

7. Vorrichtung nach Anspruch 6, **dadurch gekennzeichnet, dass** an der Deckelöffnung (12) ein Balg (13) vakuumdicht angeordnet ist, der mit dem Drehantrieb (6) vakuumdicht verbunden ist.

8. Vorrichtung nach einem der Ansprüche 2 bis 7, **dadurch gekennzeichnet, dass** die Kippachse (5) außerhalb der Vakuumkammer (17) verläuft.

9. Vorrichtung nach einem der vorhergehenden Ansprüche, **dadurch gekennzeichnet, dass** die Vakuumschleuse seitlich an der Vakuumkammer (17) angeordnet ist.

10. Vorrichtung nach einem der vorhergehenden Ansprüche, **dadurch gekennzeichnet, dass** das Handlingsystem zum Transport der Substrate (2) und/oder zum Be- und Entladen der Segmente (3) des Substrathalters (1) mit Substraten (2) horizontal und/oder vertikal bewegbare Träger, Schwenkarme und/oder Greifer aufweist.

11. Vorrichtung nach einem der vorhergehenden Ansprüche 1 bis 9, **dadurch gekennzeichnet, dass** das Handlingsystem zum Transport der Segmente (3) mit zumindest einem darauf angeordnetem Substrat (2) und/oder zum Be- und Entladen des Substrathalters (1) mit den Segmenten (3) horizontal und/oder vertikal bewegbare Träger, Schwenkarme und/oder Greifer aufweist.

12. Vorrichtung nach einem der vorhergehenden Ansprüche, **dadurch gekennzeichnet, dass** zumindest ein Segmentabschnitt des Substrathalter (1) zum Be- und/oder Entladen des Substrathalters (1) horizontal positionierbar ist.

13. Vorrichtung nach Anspruch 12, **dadurch gekennzeichnet, dass** die Vakuumschleuse und ein horizontal positionierter Segmentabschnitt des Substrathalter (1) sich gegenüberliegend angeordnet sind, wobei die horizontale Bewegungsebene des Handlingsystems geodätisch oberhalb der horizontalen Ebene des Segmentabschnittes des Substrathalters (1) liegt.

14. Vorrichtung nach Anspruch 13, **dadurch gekennzeichnet, dass** das Handlingsystem zum Beladen des Substrathalters (1) einen Träger aufweist, der horizontal in Richtung des horizontal positionierten Segmentabschnittes des Substrathalters (1) und vertikal nach unten in Richtung des horizontal positionierten Segmentabschnittes des Substrathalters (1) und/oder zum Entladen in umgekehrter Richtung bewegbar ist.

## Claims

1. Apparatus for treating, in particular coating, substrates (2), comprising a vacuum chamber (17) with a substrate holder (1) arranged therein, which substrate holder can be moved about a vertical axis of rotation (4) and can be pivoted about a tilting axis (5) extending perpendicularly in relation to the axis of rotation (4), comprising a vacuum airlock for introducing and removing substrates and comprising a handling system for transporting substrates (2) and for loading and unloading the substrate holder (1), **characterized in that** the substrate holder (1) comprises segments (3) arranged around the axis of rotation (4) in the form of a spherical cap, wherein a segment of the substrate holder can be respectively brought into line with the handling system to change the substrate.

2. Apparatus according to Claim 1, **characterized in that** the substrate holder (1) is connected to a rotary drive (6).

3. Apparatus according to Claim 2, **characterized in that** the rotary drive (6) comprises a mounting (7), wherein the mounting (7) has at least one mounting spindle (8), which is arranged on the tilting axis (5) and is connected to a bearing (9).

4. Apparatus according to Claim 3, **characterized in that** the mounting (7) is connected to a tilting drive (10).

5. Apparatus according to one of Claims 2 to 4, **characterized in that** the rotary drive (6) has a vacuum rotary feedthrough (11).

6. Apparatus according to one of the preceding Claims 2 to 5, **characterized in that** the rotary drive (6) is arranged in a vacuum-tight manner in a cover opening (12) of the vacuum chamber (17), wherein the rotary drive (6) can be pivoted in the cover opening (12).

7. Apparatus according to Claim 6, **characterized in that** a bellows (13), which is connected in a vacuum-tight manner to the rotary drive (6), is arranged in a vacuum-tight manner at the cover opening (12).

8. Apparatus according to one of Claims 2 to 7, **characterized in that** the tilting axis (5) extends outside the vacuum chamber (17).

9. Apparatus according to one of the preceding claims, **characterized in that** the vacuum airlock is arranged to the side of the vacuum chamber (17).

10. Apparatus according to one of the preceding claims, **characterized in that** the handling system for transporting the substrates (2) and/or for loading and unloading the segments (3) of the substrate holder (1) with substrates (2) has horizontally and/or vertically movable carriers, pivoting arms and/or grippers.

11. Apparatus according to one of the preceding Claims 1 to 9, **characterized in that** the handling system for transporting the segments (3) with at least one substrate (2) arranged thereupon and/or for loading and unloading the substrate holder (1) with the segments (3) has horizontally and/or vertically movable carriers, pivoting arms and/or grippers.

12. Apparatus according to one of the preceding claims, **characterized in that** at least one segment portion of the substrate holder (1) can be horizontally positioned for loading and/or unloading the substrate holder (1).

13. Apparatus according to Claim 12, **characterized in that** the vacuum airlock and a horizontally positioned segment portion of the substrate holder (1) are arranged lying opposite each other, the horizontal plane of movement of the handling system lying geodetically above the horizontal plane of the segment portion of the substrate holder (1).

14. Apparatus according to Claim 13, **characterized in that** the handling system has a carrier, which is movable horizontally in the direction of the horizontally positioned segment portion of the substrate holder (1) and vertically downwards in the direction of the horizontally positioned segment portion of the substrate holder (1) for loading the substrate holder (1) and/or in the opposite direction for unloading.

## Revendications

1. Dispositif de traitement, en particulier de revêtement, de substrats (2), comprenant une chambre à vide (17) avec un support de substrat (1) mobile autour d'un axe de rotation vertical (4) et disposé dans celle-ci, qui peut pivoter autour d'un axe de pivotement (5) s'étendant perpendiculairement à l'axe de rotation (4), un sas à vide pour l'introduction et l'extraction de substrats ainsi qu'un système de manipulation pour le transport de substrats (2) et pour le chargement et le déchargement du support de substrat (1), **caractérisé en ce que** le support de substrat (1) comprend des segments (3) disposés en forme de calotte autour de l'axe de rotation (4), dans lequel un segment respectif du support de substrat peut être aligné sur le système de manipulation pour le changement de substrat.

2. Dispositif selon la revendication 1, **caractérisé en ce que** le support de substrat (1) est relié à un entraînement de rotation (6).

3. Dispositif selon la revendication 2, **caractérisé en ce que** l'entraînement de rotation (6) comprend une monture (7), dans lequel la monture (7) présente au moins un axe de monture (8) disposé sur l'axe de pivotement (5), et qui est assemblé à un palier (9).

4. Dispositif selon la revendication 3, **caractérisé en ce que** la monture (7) est reliée à un entraînement de pivotement (10).

5. Dispositif selon l'une quelconque des revendications 2 à 4, **caractérisé en ce que** l'entraînement de rotation (6) comprend une traversée rotative à vide (11).

6. Dispositif selon l'une quelconque des revendications précédentes 2 à 5, **caractérisé en ce que** l'entraînement de rotation (6) est disposé de façon étanche au vide dans une ouverture de couvercle (12) de la chambre à vide (17), dans lequel l'entraînement de rotation (6) est apte à pivoter dans l'ouverture de couvercle (12).

7. Dispositif selon la revendication 6, **caractérisé en ce qu'**un soufflet (13) est disposé de façon étanche au vide sur l'ouverture de couvercle (12), et est raccordé de façon étanche au vide à l'entraînement de rotation (6).

8. Dispositif selon l'une quelconque des revendications 2 à 7, **caractérisé en ce que** l'axe de pivotement (5) s'étend à l'extérieur de la chambre à vide (17).

9. Dispositif selon l'une quelconque des revendications précédentes, **caractérisé en ce que** le sas à vide est disposé latéralement à la chambre à vide (17).

10. Dispositif selon l'une quelconque des revendications précédentes, **caractérisé en ce que** le système de manipulation pour le transport des substrats (2) et/ou pour le chargement et le déchargement des segments (3) du support de substrat (1) avec des substrats (2) comporte des supports, des bras pivotants et/ou des pinces mobiles horizontalement et/ou verticalement.

11. Dispositif selon l'une quelconque des revendications 1 à 9, **caractérisé en ce que** le système de manipulation pour le transport des segments (3) avec au moins un substrat (2) disposé sur ceux-ci et/ou pour le chargement et le déchargement du support de substrat (1) avec les segments (3) comporte des supports, des bras pivotants et/ou des pinces mobiles horizontalement et/ou verticalement.

12. Dispositif selon l'une quelconque des revendications précédentes, **caractérisé en ce qu'**au moins une partie de segment du support de substrat (1) pour le chargement et/ou le déchargement du support de substrat (1) peut être positionnée horizontalement.

13. Dispositif selon la revendication 12, **caractérisé en ce que** le sas à vide et une partie de segment du support de substrat (1) positionnée horizontalement sont disposés l'un en face de l'autre, dans lequel le plan de mouvement horizontal du système de manipulation est situé au point de vue géodésique au-dessus du plan horizontal de la partie de segment du support de substrat (1).

14. Dispositif selon la revendication 13, **caractérisé en ce que** le système de manipulation comprend un support, qui est mobile horizontalement en direction de la partie de segment du support de substrat (1) positionnée horizontalement et verticalement vers le bas en direction de la partie de segment du support de substrat (1) positionnée horizontalement pour le chargement du support de substrat (1) et en direction inverse pour le déchargement.
